# EUROPEAN PATENT APPLICATION

(11) **EP 3 312 672 A1**
(43) Date of publication of application: **25.04.2018**
(21) Application number: 16195047.2
(22) Date of filing: 21.10.2016

(54) **METHODS OF DETERMINING CORRECTIONS FOR A PATTERNING PROCESS, DEVICE MANUFACTURING METHOD, CONTROL SYSTEM FOR A LITHOGRAPHIC APPARATUS AND LITHOGRAPHIC APPARATUS**

(71) Applicant: ASML Netherlands B.V., 5500 AH Veldhoven (NL)
(72) Inventor: KOU, Weitian, 5500 AH Veldhoven (NL); YPMA, Alexander, 5500 AH Veldhoven (NL); HAUPTMANN, Marc, 5500 AH Veldhoven (NL); KUPERS, Michiel, 5500 AH Veldhoven (NL); VERGAIJ-HUIZER, Lydia, Marianna, 5500 AH Veldhoven (NL); WALLERBOS, Erik, Johannes, Maria, 5500 AH Veldhoven (NL); DELVIGNE, Erik, Henri, Adriaan, 5500 AH Veldhoven (NL)
(74) Representative: Peters, John Antoine

(57) **Abstract**

Disclosed is a method of determining a correction for a process parameter related to a lithographic process on a substrate and associated apparatuses. The lithographic process comprises a plurality of runs during each one of which a pattern is applied to one or more substrates. The method comprises obtaining pre-exposure metrology data describing a property of the substrate; obtaining post-exposure metrology data comprising one or more measurements of the process parameter having been performed on one or more previously exposed substrates; assigning to the substrate, a class membership status from a plurality of classes, based on said pre-exposure metrology data; and determining the correction for the process parameter based on said class membership status and said post-exposure metrology data.

## Description

### BACKGROUND

### Field of the Invention

0001 The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

### Related Art

0002 A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

0003 Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable, however, and it remains important to trace and eliminate as many causes of such distortions as possible.

0004 Modern lithographic process and products are so complex that issues due to processing are difficult to trace back to the root cause. Overlay and alignment residuals typically show patterns over the wafer (of the process and/or litho tool). This may be interpreted as a non-correctable quantity with respect to a predefined model, while visual inspection and detailed analysis of the fingerprint may give an indication of causes and correction strategies. The spatial pattern in the fingerprint is not used to quantify the fingerprint, nor the observation that multiple causes may show up simultaneously in the apparent fingerprint. Overlay measurements are not generally available for each individual wafer, and the relation to the processing history and context is not generally known or used. Furthermore, it is difficult and time-consuming to make a list of all possible sources of spatial variation for the machine and process at hand.

0005 Aside from the problem of identifying causes of processing errors, process performance monitoring systems have been implemented which allow measurement of performance parameters to be made from processed products, which then are used to calculate corrections for use in processing subsequent products. A limitation with current performance monitoring systems is that there is a compromise between the amount of time and equipment dedicated to performance monitoring, and the speed and accuracy with which corrections can be implemented. In a "run-to-run" control strategy historic performance measurements are fed back to calculate new process corrections using (e.g., in-line) metrology performed between and/or during "runs", which may comprise one or more lots. In previous run-to-run control strategies, each run comprised a "lot" of, typically 25 substrates. Improved lithographic apparatus hardware has enabled wafer level control, whereby a run may comprise a single substrate. However, performing a full overlay measurement on each substrate to take advantage of such wafer level control would be prohibitive in term of time and throughput.

### SUMMARY OF THE INVENTION

0006 The present invention aims to improve systems for control of performance in parameters such as overlay in lithographic processes.

0007 In another aspect, the invention aims to enable optimization of run-to run control strategies during high-volume manufacture.

0008 According to a first aspect of the present invention, there is provided a method of determining a correction for a process parameter related to a lithographic process on a substrate, said lithographic process comprising a plurality of runs during each one of which a pattern is applied to one or more substrates, said method comprising: obtaining pre-exposure metrology data describing a property of the substrate; obtaining post-exposure metrology data comprising one or more measurements of the process parameter having been performed by an equivalent lithographic process on one or more previously exposed substrates of said lithographic process; assigning to the substrate, a class membership status from a plurality of classes, based on said pre-exposure metrology data; and determining the correction for the process parameter based on said class membership status and said post-exposure metrology data.

0009 The invention yet further provides a method of manufacturing devices wherein device features are formed on a series of substrates by a patterning process, wherein corrections for a process parameter of said patterning process are determined by performing the method of the first aspect.

0010 The invention yet further provides a control system for a lithographic apparatus, the control system comprising: storage for receiving pre-exposure metrology data describing a property of a substrate and post-exposure metrology data comprising one or more measurements of the process parameter having been performed on one or more previous substrates; and a processor operable to: assign to the substrate, a class membership status from a plurality of classes, based on said pre-exposure metrology data; and determine a correction for a process parameter based on said class membership status and said post-exposure metrology data.

0011 The invention yet further provides a lithographic apparatus including a control system according to the aspect of the invention as set forth above.

0012 The invention yet further provides a method of dynamically updating one or more classes and/or corrections for a process parameter related to a lithographic process on a substrate, wherein a correction out of a plurality of corrections is applied to the process parameter for each substrate based on a class membership status assigned to that substrate said method comprising: obtaining post-exposure metrology data describing a performance parameter of said substrate; and dynamically updating said one or more of said classes and/or plurality of corrections based on the post-exposure metrology data.

0013 The invention yet further provides a computer program product containing one or more sequences of machine-readable instructions for implementing calculating steps in a method according to any aspects of the invention as set forth above.

0014 These and other aspects and advantages of the apparatus and methods disclosed herein will be appreciated from a consideration of the following description and drawings of exemplary embodiments.

### BRIEF DESCRIPTION OF THE DRAWINGS

0015 Embodiments of the invention will now be described, by way of example only, with reference to the accompanying schematic drawings in which corresponding reference symbols indicate corresponding parts, and in which:
Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figure 4 is a schematic diagram of an advanced process control method for controlling the apparatus of Figure 1 according to known practice;
Figure 5 is a flowchart describing an initial set-up phase according to an embodiment of the invention; and
Figure 6 is a flow diagram conceptually illustrating a method according to an embodiment of the invention.

### DETAILED DESCRIPTION OF EXEMPLARY EMBODIMENTS

0016 Before describing embodiments of the invention in detail, it is instructive to present an example environment in which embodiments of the present invention may be implemented.

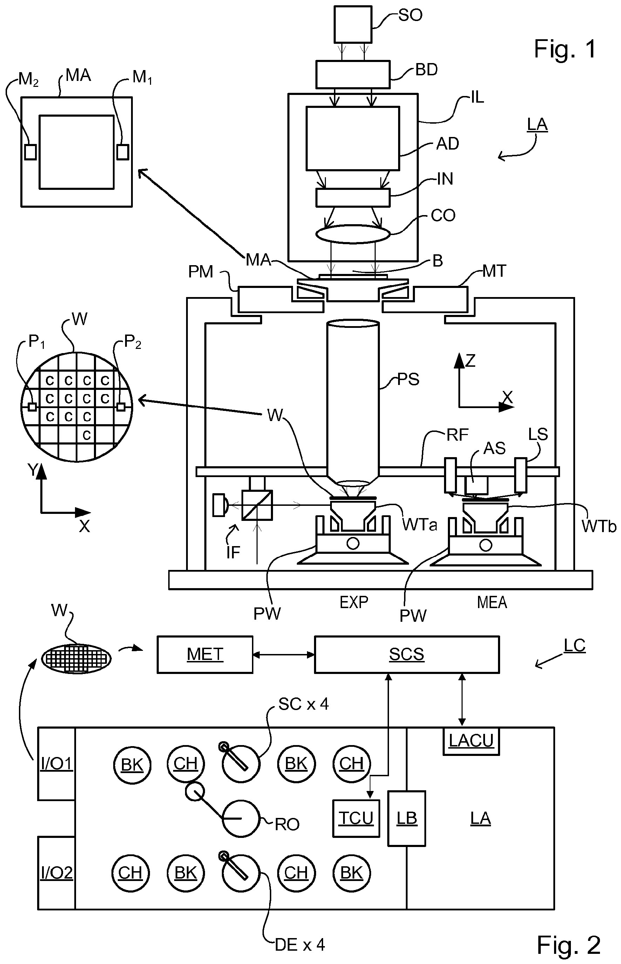

0017 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0018 The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

0019 The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

0020 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0021 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0022 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0023 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0024 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0025 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0026 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

0027 Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

0028 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned. 0029 Combinations and/or variations on the above described modes of use or entirely different modes of use may also be employed.

0030 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0031 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0032 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

0033 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0034 The metrology step with metrology system MET can also be done after the resist pattern has been etched into a product layer. The latter possibility limits the possibilities for rework of faulty substrates but may provide additional information about the performance of the manufacturing process as a whole.

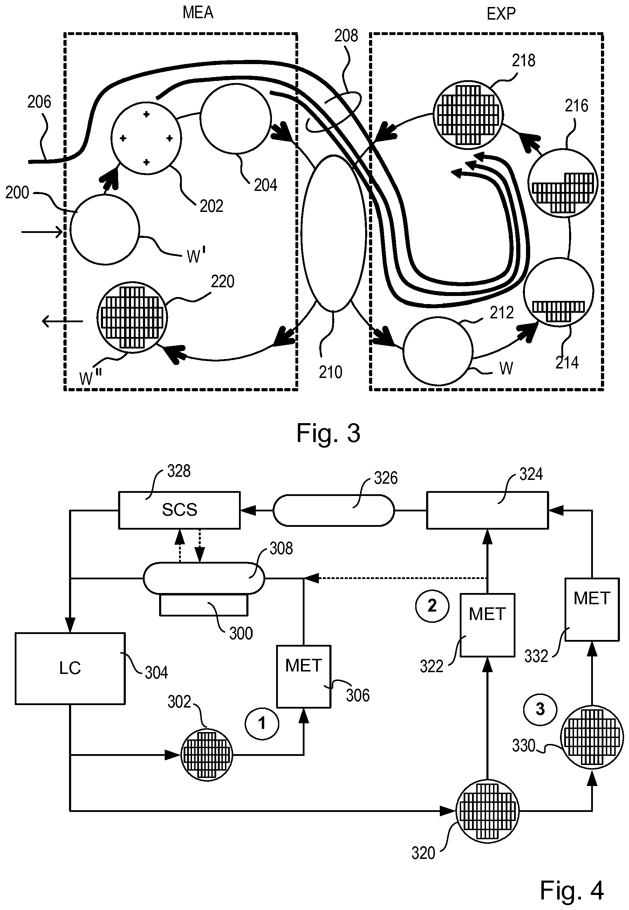

0035 Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

0036 On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

0037 Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

0038 The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

0039 At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

0040 At step 204, a map of wafer height (Z) against X-Y position is measured also using the level sensor LS. Primarily, the height map is used only to achieve accurate focusing of the exposed pattern. It may be used for other purposes in addition.

0041 When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

0042 At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.
By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

### Advanced Process Control using Performance Data

0043 For best performance, historical performance data relating to the lithography process are generally used in addition to measurements made when a current substrate is loaded into the lithographic apparatus. For this purpose, measurements of performance are made with the metrology system MET (Figure 2). Different forms of advanced process control can be implemented. Figure 4 illustrates only one example, implementing a known stability control method.

0044 Figure 4 depicts a stability module 300. This module is for example an application running on a processor, for example within the control unit LACU or the supervisory control system SCS of Figure 2. Shown are three main process control loops, labeled 1, 2, 3. The first loop provides local control of the lithography apparatus using the stability module 300 and monitor wafers. A monitor wafer 302 is shown being passed from a lithography cell 304, which may be the lithocell LC of Figure 2 for example. Monitor wafer 304 has been exposed with a calibration pattern to set 'baseline' parameters for focus and overlay. At a later time, a metrology tool 306 reads these baseline parameters, which are then interpreted by the stability module 300 so as to calculate stability corrections 308 specific to this lithocell. This performance data can be fed back to the lithography cell 304, and used when performing further exposures. The exposure of the monitor wafer may involve printing a pattern of marks on top of reference marks. By measuring overlay error between the top and bottom marks, deviations in performance of the lithographic apparatus can be measured, even when the wafers have been removed from the apparatus and placed in a metrology tool.

0045 The second (APC) control loop is based on measurements of performance parameters such as focus, dose, and overlay on actual product wafers. An exposed product wafer 320 is passed to metrology tool 322, which may be the same or different to the metrology tool 306 in the first control loop. At 322 information relating for example to parameters such as critical dimension, sidewall angles and overlay is determined and passed to an Advanced Process Control (APC) module 324. This data is also passed to the stability module 300. Process corrections 326 are calculated and used by the supervisory control system (SCS) 328, providing control of the lithocell 304, in communication with the stability module 300.

0046 The third control loop is to allow metrology integration into the second (APC) control loop, for example in double patterning applications. An etched wafer 330 is passed to metrology unit 332 which again may be the same or different to the metrology tool 306, 322 used in the first and/or second control loop. Metrology tool 332 measures performance parameters such as critical dimensions, sidewall angles and overlay, read from the wafer. These parameters are passed to the Advanced Process Control (APC) module 324. The loop continues the same as with the second loop.

0047 Current process correction strategies in a high volume manufacturing (HVM) environment are typically performed on a per chuck and per lot basis. However, more recently a per substrate correction is considered. It then becomes possible to define process corrections per substrate instead of per lot. Practical strategies for taking advantage of a per substrate correction for process control at the per substrate level (herein referred to as wafer level control or WLC) need to be devised. It is expensive (particularly in terms of time and throughput) to perform overlay metrology for each processed substrate. Instead, a per substrate prediction of the "process fingerprint" can be made. The process fingerprint (or signature) describes the distortion or other deformations imposed on a substrate by a particular process step and/or process tool. Such predictions could be based on the exposure sequence (which is known in advance) or the context/processing history. However, this has some disadvantages. Firstly, keeping track of and managing all historic processing steps, especially for a higher layer, requires significant effort. Secondly, it may be difficult to establish a clear relationship between process tools and the impact on overlay.

0048 Using metrology data which is generally generated on a more regular basis, for example alignment data or levelling data which is generated on a per substrate basis, is an alternative to reduce substrate-to-substrate variations. However, considering specifically the example of alignment data, the correction capacity is limited: to avoid a throughput penalty only a limited number of alignment marks can be measured; the alignment model is often limited to a global (interfield) model; and often the alignment marks suffer from process-induced mark damage, resulting in less reliable measurements.

0049 It is proposed to group substrates together and determine a correction based on the substrate group in a run-to-run, wafer level control strategy. In the HVM environment, the cluster assignment could be performed according to the context history of the substrates. However, as already described, tracking context history is undesirably burdensome. Instead, it is proposed to group substrates according to pre-exposure metrology data which correlates with a post-exposure performance parameter (e.g., overlay) being controlled. By grouping the substrates in this way, it is possible to achieve close to a "per substrate" accuracy while benefitting from relatively large averaging across the substrates per group.

0050 In this context, pre-exposure metrology data comprises metrology data from measurements performed prior to exposure of the layer for which the performance parameter is being controlled, i.e., the term "pre-exposure" is relative to exposure of the next layer. As such, pre-exposure metrology data may comprise measurements performed on a substrate on which previous layers have been exposed, for control of exposure of a further layer on the substrate.

0051 Pre-exposure data may comprise data from measurements performed prior to loading on the lithographic apparatus (scanner) for exposure of the current layer, or subsequent to loading on the lithographic apparatus (scanner) for exposure of the current layer. In the latter example, the pre-exposure data may comprise preparatory metrology for the exposure of that layer. In an embodiment, the pre-exposure metrology data may comprise alignment data. The alignment data may comprise measurements performed in preparation for exposure of the current layer subsequent to loading of the substrate. Alternatively, or in combination, the alignment data may comprise measurements performed in preparation for exposure of a previous layer, i.e., prior to loading of the substrate for measurement and exposure of the current layer. Alternatively, or in combination, the pre-exposure metrology data may comprise levelling data describing the shape of the substrate. As with alignment data, the levelling data may be from measurements performed in preparation for exposure of the current layer, or of previous layers. Alternatively, or in combination, the pre-exposure metrology data may comprise wafer geometry data and/or in-plane distortion data.

0052 Considering the example of the pre-exposure metrology data comprising alignment data, this alignment data may be measured across a substrate at the measurement station of the lithography tool. The alignment data may comprise a plurality of vectors across the substrate, each vector representing the position and displacement of a mark position measured by the alignment sensor AS, relative to a nominal position (e.g., a positional deviation), for a particular mark on the substrate. All the substrates may have the same spatial distribution of marks and measurements, but the actual deviations are generally unique to each substrate. Analysis of the pre-exposure metrology data (alignment measurements) over a population of substrates can be performed so as to reveal various "fingerprints" that may be hidden in the data. Similarly, fingerprints can be obtained from a substrate topography or shape measurement measured, for example, using level sensor LS. It is known that any of the different steps in the production of the processed substrate can contribute its own fingerprint to the distribution of position errors across the substrate. Bearing in mind that a real product may have gone through dozens of process steps, including many cycles of patterning and processing in different apparatuses and different types of apparatuses, it becomes very difficult to know which types of apparatus, let alone which individual apparatuses, have contributed to errors present in the finished product.

0053 The proposed method may comprise two phases. An initial set-up or training phase is performed in order to categorize a set of substrates into plural classes. This set-up phase may comprise training a classifier to categorize the pre-exposure metrology data (input objects) according to (e.g., labelled by) characteristics of the performance parameter (output). Any suitable (e.g., supervised) machine learning technique for hard or soft classification of data may be used, for example linear discriminant analysis, logistic regression or a support vector classifier. Other suitable classification methods are described in WO2015049087, herein incorporated by reference. This describes methods where alignment data or other measurements are made at stages during the performance of a lithographic process to obtain object data representing positional deviation or other parameters measured at points spatially distributed across each wafer. This object data is used to obtain diagnostic information by performing a multivariate analysis to decompose the set of said vectors representing the wafers in said multidimensional space into one or more component vectors. Diagnostic information about the industrial process is extracted using the component vectors. The performance of the lithographic process for subsequent product units can be controlled based on the extracted diagnostic information.

0054 The training phase may be performed on historical data from a plurality of substrates for which the pre-exposure metrology data and post-exposure metrology data (measurements of the performance parameter) are available. For the specific examples already mentioned, alignment fingerprints (which describe substrate grid distortion in the substrate plane) or substrate shapes or topographies (which describe substrate distortions in the direction normal to the substrate plane) and are classified according to a characteristic of corresponding overlay measurements (for example an overlay fingerprint characteristic). The result of this training phase may comprise a plurality of substrate classes, each labelled by a common fingerprint or topography characteristic and corresponding coefficients. Each performance parameter characteristic will have an associated process correction (e.g., an optimal correction recipe). In an embodiment, the set-up phase may coincide with normal production (the control phase, based on lot based process correction).

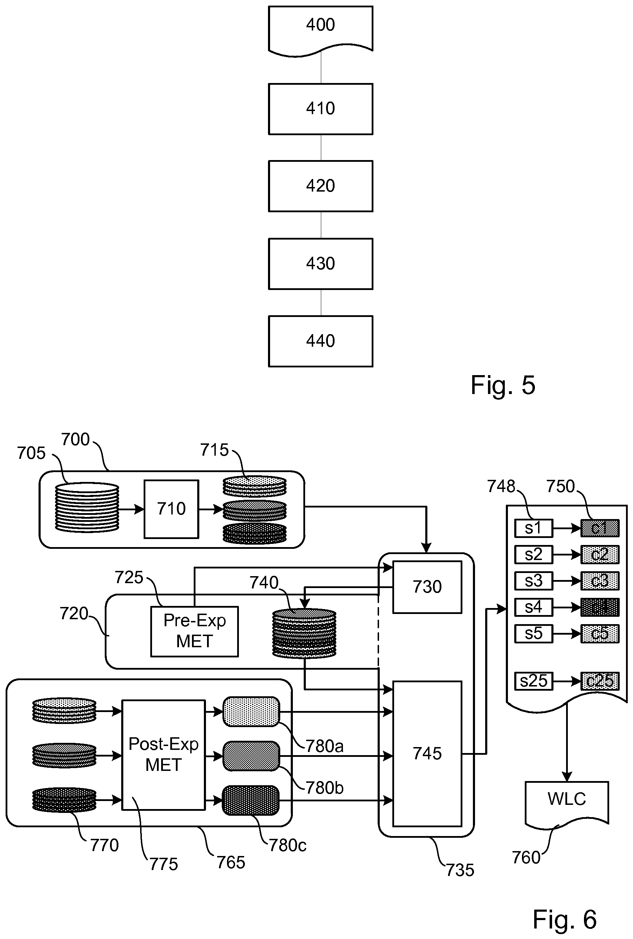

0055 Figure 5 is a flowchart describing a specific example of the training phase for predictive substrate classification. The set-up phase may comprise using a supervised learning algorithm on (e.g., historic) training data 400 comprising pre-exposure metrology data for a number of substrates labelled by post-exposure metrology data describing the performance parameter for those substrates. In a specific example, the pre-exposure metrology data may comprise alignment fingerprints or substrate topographies and the post-exposure metrology data may comprise overlay, critical dimension or focus fingerprints. Firstly, an intra-lot clustering step 410 is performed to identify per-lot clusters. Following this, an inter-lot clustering step 420 is performed to identify similar fingerprints/topologies between lots. A classification step 430 is then performed to train a classifier using the training data. During this step, pre-exposure metrology data classes (i.e., the substrate classes) are defined. A validation step 440 is then performed. In this validation step 440, substrates are assigned to the substrate classes based upon historical data. A shadow mode simulation of performance parameter benefit is then performed per process correction thread.

0056 In a second phase or control phase, pre-exposure metrology data for a substrate is obtained, for example by performing alignment and/or levelling metrology on the substrate. This metrology may be performed in a lithographic apparatus as part of an alignment and substrate measuring process; for example using, respectively, the alignment sensor AS and level sensor LS of Figure 1 by the methods described above. Based on this pre-exposure metrology data, the substrate is assigned a class membership status. The class membership status may comprise each of the substrates being assigned membership of a single class (hard classification) or partial membership of some or all classes (soft classification). In either case, the classes will be one of the substrate classes determined during the set-up phase (or possibly determined during this control phase as will be described later). The pre-exposure metrology data may comprise measurement of any common physical property for all substrates which is sensitive to substrate process variations; for example: an alignment fingerprint or substrate topography or flatness measurement. Based on the class membership status, an associated process correction will be identified. This associated process correction may then be used during exposure of the layer being exposed.

0057 In an embodiment, the pre-exposure metrology on the substrate and the subsequent categorization of the substrate, identification of associated corrections and exposure of the layer using the corrections are all performed by the lithographic apparatus. This will mean that the correction loop will be short (the pre-exposure metrology data is directly used in the subsequent exposure step). No additional tool to measure the substrate is needed.

0058 In an embodiment, where the lithographic apparatus comprises more than one support (more than one chuck) as illustrated in Figure 1, the chuck assignment may be taken into account when identifying corrections based on the substrate categorization. As such, corrections may be associated to a particular substrate class on a per chuck basis.

0059 The performance parameter (e.g., overlay) will be measured post-exposure on some or all of the substrates. The resulting metrology data can then be modeled and the parameters used to update or replace the process corrections associated with the substrate classes applicable to the measured substrates. Process correction updates may be implemented with a time filter and/or averaged (e.g. using a moving average). The modeling may be done once for every substrate class. Alternatively, the modeling may comprise modeling all the parameters at once using both class-specific and shared parameters.

0060 In an embodiment, during the control phase, it may be determined that the pre-exposure metrology data for a particular substrate does not properly belong to any of the substrate classes identified in the training phase, according to a metric. For example, the metric may be a distance metric, and a particular substrate may be deemed to not properly belong to any substrate class if the distance metric to the nearest substrate class is above a threshold value. In a specific example, the distance metric may refer to the distance between the measured alignment fingerprint (or other pre-exposure metrology data) of a substrate and the metrology fingerprint defining the closest class. In such an embodiment, the method may comprise updating the substrate classes by updating the corresponding characteristic which characterizes one or more of the substrate classes such that one of the substrate classes now encompasses the characteristic of the pre-exposure metrology data for this substrate. In this way, the characteristic of each substrate class can be updated while maintaining consistency in the number of classes. By way of an alternative, an embodiment may comprise adding a new class corresponding to a characteristic of the pre-exposure metrology data for the uncategorized substrate. The performance parameter (e.g., overlay) for this substrate would then be measured post-exposure and used to label the pre-exposure metrology data for the uncategorized substrate. Also, corresponding corrections should be determined for the new substrate class (e.g., by modeling), which can then be used for correcting subsequent substrates that are categorized in this class. By way of an alternative, substrates which do not fit any class may be reworked and set aside.

0061 The selection of substrates for post-exposure measurement may be optimized during the control phase. This optimization may comprise selecting substrates which are identified as being the most representative of its corresponding substrate class. This may comprise selecting a substrate for which its associated distance metric used in its categorization is smaller than the distance metrics of the other substrates in the class. However, substrate selection based solely on representativeness may cause some classes to be updated more often than others. Therefore, in another embodiment, substrates may be selected based on a combination of representativeness and how recently the corresponding correction set was last updated.

0062 Figure 6 shows a flowchart conceptually describing a method according to a specific embodiment. A set-up phase 700 comprises obtaining historic training data for a plurality of substrates 705 and performing a clustering and classification step 710 to obtain a plurality of substrate classes 715. Within a lithographic apparatus 720, pre-exposure metrology 725 is performed. The resultant pre-exposure metrology data is processed 730 within processor 735, to assign each substrate to a substrate class 740. The processor 735 then assigns 745 a process correction 750 to each substrate 748 in accordance with the assigned class. Processor 735 may be integrated with (e.g., form part of) lithographic apparatus 720 or may be a stand-alone processing module. At step 760, each assigned process correction 750 is used for wafer level control when exposing the next layer on that substrate. Within a metrology apparatus (such as a scatterometer) 765, one or more already categorized substrates 770 are measured post-exposure 775 (e.g., substrates which have been exposed prior to the plurality of substrates 705 being introduced to lithographic apparatus 720). For each substrate class, a correction update 780a, 780b, 780 is determined and fed to the processor 735 for use when the algorithm assigns a process correction 745. The correction update may be a weighted based on class membership status of each substrate, particularly where a soft assignment method is used. The method may further comprise an optimization step (not shown) which optimizes the updated process corrections 750, such that pre-optimized process corrections are selected from when assigning process corrections at step 745 (one pre-optimized correction per class).

0063 In this way, pre-exposure metrology data can be used in an automated solution for run-to-run wafer level control of a lithographic process without any requirement for processing history information to be tracked, nor offline measurements to be made.

0064 In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

0065 Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

0066 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0067 The breadth and scope of the present invention should not be limited by any of the above-described exemplary embodiments, but should be defined only in accordance with the following claims and their equivalents.

## Claims

1. A method of determining a correction for a process parameter related to a lithographic process on a substrate, said lithographic process comprising a plurality of runs during each one of which a pattern is applied to one or more substrates, said method comprising:
obtaining pre-exposure metrology data describing a property of the substrate;
obtaining post-exposure metrology data comprising one or more measurements of the process parameter having been performed by an equivalent lithographic process on one or more previously exposed substrates of said lithographic process;
assigning to the substrate, a class membership status from a plurality of classes, based on said pre-exposure metrology data; and
determining the correction for the process parameter based on said class membership status and said post-exposure metrology data.

2. A method as claimed in claim 1, comprising performing the lithographic process on the substrate using said correction.

3. A method as claimed in claim 1 or 2, comprising performing a pre-exposure metrology step on said substrate to obtain said pre-exposure metrology data.

4. A method as claimed in claim 3, wherein said pre-exposure metrology step, and a subsequent step of performing the lithographic process on the substrate using said correction is performed by the same lithographic apparatus.

5. A method as claimed in claim 4, wherein the steps of assigning a class membership status and determining the correction for the process parameter are also performed by the same lithographic apparatus.

6. A method as claimed in any preceding claim, wherein the pre-exposure metrology data comprises alignment data describing across-substrate grid distortions in the substrate plane.

7. A method as claimed in any preceding claim, wherein the pre-exposure metrology data comprises data describing the shape of the substrate in a direction perpendicular to the substrate plane.

8. A method as claimed in any preceding claim, wherein the pre-exposure metrology data comprises leveling data.

9. A method as claimed in any preceding claim, wherein pre-exposure metrology data comprises data relating to a previously exposed layer on the substrate.

10. A method as claimed in any of claims 1 to 8, wherein pre-exposure metrology data comprises data relating to a layer to be exposed on the substrate in a subsequent step of the lithographic process.

11. A method as claimed in any preceding claim, wherein said assignment step comprises performing a hard assignment wherein said class membership status is such that each substrate is always assigned to a single class, or else is unclassified.

12. A method as claimed in any of claims 1 to 11, wherein said assignment step comprises performing a soft assignment wherein said class membership status is such that each substrate may be assigned a degree of membership to one or more of said classes.

13. A method as claimed in claim 12, wherein the step of determining the correction for the process parameter is based on weighing of corrections associated with at least two classes based on the degrees of membership of that substrate to the at least two classes.

14. A method as claimed in any preceding claim, comprising an initial training stage wherein said plurality of classes are determined from a plurality of labeled sets of said pre-exposure metrology data, each labeled set relating to a different substrate of a plurality of substrates and labeled by post-exposure metrology data relating to that substrate.

15. A method as claimed in claim 14, wherein said initial training stage comprises performing a supervised classification algorithm which trains a classifier on said labeled sets of pre-exposure metrology data so as to define said plurality of classes.

16. A method as claimed in claim 15, wherein the initial training stage comprises, prior to training the classifier, the steps of identifying intra-lot clusters and identifying inter-lot clusters in said pre-exposure metrology data.

17. A method as claimed in claim 14, 15 or 16, wherein the initial training stage comprises a validation step comprising assigning substrates to said plurality of classes based on historic data and simulating the effect on said post-exposure metrology data.

18. A method as claimed in any of claims 14 to 17, wherein said post-exposure metrology data comprises overlay data.

19. A method as claimed in any preceding claim, comprising the step of identifying for a particular class, a substrate which is most representative of said class.

20. A method as claimed in claim 19, comprising measuring said substrate which is most representative of said class; and
updating a correction for the process parameter corresponding to said class based on said measurement.

21. A method as claimed in any preceding claim, wherein the step of determining the correction for the process parameter based on said class membership status also determines the correction for the process parameter based on which chuck the substrate is mounted on during the lithographic process.

22. A method as claimed in any preceding claim, comprising measuring said substrate post-exposure to obtain post-exposure measurements of said substrate; and
using said post-exposure measurements of said substrate to update the correction(s) for said process parameter corresponding to the class membership status assigned to said substrate.

23. A method as claimed in any preceding claim, wherein, where it is determined that said pre-exposure metrology data is of an insufficient fit to any of said plurality of classes according to a metric, said method comprises updating said plurality of classes such that said pre-exposure metrology data can be classified.

24. A method as claimed in claim 23, wherein said step of updating said plurality of classes comprises maintaining the same number of classes, and updating a data characteristic defining one or more of said classes, such that the pre-exposure metrology data for this substrate is a sufficient fit for at least one of the classes according to the metric.

25. A method as claimed in claim 23, wherein said step of updating said plurality of classes comprises adding a new class defined by a data characteristic having an improved fit to said substrate relative to the other classes.

26. A method as claimed in any preceding claim, comprising performing said method for each substrate of a run.

27. A method as claimed in claim 26, wherein said post-exposure metrology data comprises one or more measurements of the process parameter having been performed by an equivalent lithographic process on one or more previously exposed substrates of the same run of said lithographic process.

28. A method as claimed in claim 26, wherein said post-exposure metrology data comprises one or more measurements of the process parameter having been performed by an equivalent lithographic process on one or more previously exposed substrates of a previous run of said lithographic process.

29. A method of manufacturing devices wherein device features are formed on a series of substrates by a patterning process, wherein corrections for a process parameter of said patterning process are determined by performing the method of any of claims 1 to 28 and 51 to 59.

30. A control system for a lithographic apparatus, the control system comprising:
storage for receiving pre-exposure metrology data describing a property of a substrate and post-exposure metrology data comprising one or more measurements of the process parameter having been performed on one or more previous substrates; and
a processor operable to:
assign to the substrate, a class membership status from a plurality of classes, based on said pre-exposure metrology data; and
determine a correction for a process parameter based on said class membership status and said post-exposure metrology data.

31. A control system as claim 30, wherein the pre-exposure metrology data comprises alignment data describing across-substrate grid distortions in the substrate plane.

32. A control system as claimed in claim 30 or 31, wherein the pre-exposure metrology data comprises data describing the shape of the substrate in a direction perpendicular to the substrate plane.

33. A control system as claimed in any of claims 30 to 32, wherein the pre-exposure metrology data comprises leveling data.

34. A control system as claimed in any of claims 30 to 33, wherein pre-exposure metrology data comprises data relating to a previously exposed layer on the substrate.

35. A control system as claimed in any of claims 30 to 33, wherein pre-exposure metrology data comprises data relating to a layer to be exposed.

36. A control system as claimed in any of claims 30 to 35, wherein said processor is operable to perform a hard assignment wherein said class membership status is such that each substrate is always assigned to a single class, or else is unclassified.

37. A control system as claimed in any of claims 30 to 35, wherein said processor is operable to perform a soft assignment wherein said class membership status is such that each substrate may be assigned a degree of membership to one or more of said classes.

38. A control system as claimed in claim 37, wherein the correction is determined for the process parameter based on weighing of corrections associated with at least two classes based on the degrees of membership of that substrate to the at least two classes.

39. A control system as claimed in any of claims 30 to 38, wherein the processor is operable to determine for a particular class, a substrate which is most representative of said class.

40. A control system as claimed in claim 39, wherein the processor is operable to update a correction for the process parameter corresponding to said class based on a measurement of said substrate which is most representative of said class.

41. A control system as claimed in any of claims 30 to 40, wherein the correction determined for the process parameter based on said class membership status is also based on which chuck the substrate is mounted on during the lithographic process.

42. A control system as claimed in any of claims 30 to 41, wherein the processor is operable to use post-exposure measurements of said substrate to update the correction(s) for said process parameter corresponding to the class membership status assigned to said substrate.

43. A control system as claimed in any of claims 30 to 42, wherein, where the processor determines that said pre-exposure metrology data is of an insufficient fit to any of said plurality of classes according to a metric, said processor is operable to update said plurality of classes such that said pre-exposure metrology data can be classified.

44. A control system as claimed in claim 43, wherein updating of said plurality of classes comprises maintaining the same number of classes, and updating a data characteristic defining one or more of said classes, such that the pre-exposure metrology data for this substrate is a sufficient fit for at least one of the classes according to the metric.

45. A control system as claimed in claim 43, wherein said updating of said plurality of classes comprises adding a new class defined by a data characteristic having an improved fit to said substrate relative to the other classes.

46. A control system operable to control a suitable apparatus to perform the method of any of claims 1 to 28 and 51 to 59.

47. A lithographic apparatus comprising the control system as claimed in any of claims 30 to 46.

48. A lithographic apparatus as claimed in claim 47 comprising a measurement system, a patterning system and a control system, said measurement system being operable to perform pre-exposure metrology on said substrate to obtain said pre-exposure metrology data, and said patterning system being operable to form device features on said substrate in a patterning process using said correction for a process parameter of said patterning process.

49. A computer program product containing one or more sequences of machine-readable instructions for implementing the steps of a method of any of claims 1 to 29 and 51 to 59.

50. A computer program product containing one or more sequences of machine-readable instructions for causing a processing device or system of processing devices to implement the control system of any of claims 30 to 46.

51. A method of dynamically updating one or more classes and/or corrections for a process parameter related to a lithographic process on a substrate, wherein a correction out of a plurality of corrections is applied to the process parameter for each substrate based on a class membership status assigned to that substrate said method comprising:
obtaining post-exposure metrology data describing a performance parameter of said substrate; and
dynamically updating said one or more of said classes and/or plurality of corrections based on the post-exposure metrology data.

52. A method as claimed in claim 51, wherein said post-exposure metrology data comprises overlay data.

53. A method as claimed in claim 51 or 52, wherein said dynamically updating step comprises dynamically updating corrections for a process parameter corresponding to a class based on a measurement of a substrate which is determined to be most representative of said class.

54. A method as claimed in any of claims 51 to 53, wherein said dynamically updating step comprises updating the one or more corrections of said plurality of corrections which correspond to the class membership status of said substrate.

55. A method as claimed in any of claims 51 to 54, wherein said dynamically updating step comprises applying a weighted update to said plurality of corrections based on the class membership status of said substrate

56. A method as claimed in any of claims 51 to 55, comprising the steps of obtaining pre-exposure metrology data describing a property of each substrate;
assigning to the substrate, a class membership status from a plurality of classes, based on said pre-exposure metrology data; and
determining the correction for the process parameter based on the class membership status.

57. A method as claimed in claim 56, wherein, where it is determined that said pre-exposure metrology data is of an insufficient fit to any of said plurality of classes according to a metric, said dynamically updating step comprises dynamically updating said plurality of classes such that said pre-exposure metrology data can be classified.

58. A method as claimed in claim 57, wherein said step of dynamically updating said plurality of classes comprises maintaining the same number of classes, and updating a data characteristic defining one or more of said classes, such that the pre-exposure metrology data for this substrate is a sufficient fit for at least one of the classes according to the metric.

59. A method as claimed in claim 57, wherein said step of dynamically updating said plurality of classes comprises adding a new class defined by a data characteristic having an improved fit to said substrate relative to the other classes.
